# EUROPEAN PATENT APPLICATION

(11) **EP 4 622 408 A1**
(43) Date of publication of application: **24.09.2025**
(21) Application number: 23910156.1
(22) Date of filing: 13.12.2023
(51) Int. Cl.: H05K 5/02

(54) **MIDDLE FRAME ASSEMBLY AND ELECTRONIC DEVICE**

(30) Priority: 27.12.2022 CN 202211707250
(71) Applicant: Huawei Technologies Co., Ltd., Shenzhen, Guangdong 518129 (CN)
(72) Inventor: ZHANG, Hui, Shenzhen, Guangdong 518129 (CN); WANG, Tao, Shenzhen, Guangdong 518129 (CN); WANG, Wenlong, Shenzhen, Guangdong 518129 (CN)
(74) Representative: Gill Jennings & Every LLP
(86) International application number: PCT/CN2023/138518
(87) International publication number: WO 2024/140226

(57) **Abstract**

Embodiments of this application provide a middle frame assembly and an electronic device. The middle frame assembly includes at least a middle frame, a heat dissipation plate, and an electrical connection structure. The middle frame has a hollowed-out region. The heat dissipation plate includes a main body portion and a connection portion, at least the main body portion of the heat dissipation plate is disposed in the hollowed-out region, and the connection portion is securely fastened to the middle frame. The electrical connection structure is configured to electrically connect the heat dissipation plate to the middle frame, so that the heat dissipation plate is grounded through the middle frame. Therefore, when a large-area heat dissipation plate is used, impact, on an antenna, that is of clutter jamming caused by an electromagnetic wave generated at a lap joint between the heat dissipation plate and the middle frame, may be reduced, thereby avoiding sharp deterioration in performance of the antenna, ensuring that the performance of the antenna is within a proper range, and ensuring reliability of the electronic device.

## Description

This application claims priority to Chinese Patent Application No. 202211707250.X, filed with the China National Intellectual Property Administration on December 27, 2022 and entitled "MIDDLE FRAME AS SEMBLY AND ELECTRONIC DEVICE", which is incorporated herein by reference in its entirety.

### TECHNICAL FIELD

Embodiments of this application relate to the field of electronic device technologies, and in particular, to a middle frame assembly and an electronic device.

### BACKGROUND

Heat dissipation plates for heat dissipation are disposed inside electronic devices such as a mobile phone and a tablet computer, and the electronic devices may work within proper temperature ranges by using the heat dissipation plates.

In a related technology, to meet a relatively large heat dissipation requirement of an electronic device, a large-area heat dissipation plate is used for heat dissipation, so that the electronic device works within a proper temperature range. However, an electromagnetic wave that causes clutter jamming for antennas on two sides of a middle frame is generated at a lap joint between the large-area heat dissipation plate and the middle frame of the electronic device, and consequently, performance of the antennas sharply deteriorates.

Therefore, how to avoid sharp deterioration in the performance of the antennas when the large-area heat dissipation plate is used for heat dissipation becomes an urgent problem to be resolved.

### SUMMARY

Embodiments of this application provide a middle frame assembly and an electronic device, so that when a large-area heat dissipation plate is used for heat dissipation, sharp deterioration in performance of an antenna can be avoided, to ensure reliability of the electronic device.

A first aspect of this application provides a middle frame assembly, including at least a middle frame, a heat dissipation plate, and an electrical connection structure. The middle frame has a hollowed-out region. The heat dissipation plate includes a main body portion and a connection portion, at least the main body portion of the heat dissipation plate is disposed in the hollowed-out region, and the connection portion is securely fastened to the middle frame. The electrical connection structure is configured to electrically connect the heat dissipation plate to the middle frame, so that the heat dissipation plate is grounded through the middle frame.

Because the heat dissipation plate may be electrically connected to the middle frame by using the electrical connection structure, the heat dissipation plate may be grounded through the middle frame. Therefore, when a large-area heat dissipation plate is used for heat dissipation, impact, on an antenna, that is of clutter jamming caused by an electromagnetic wave generated at a lap joint between the heat dissipation plate and the middle frame, may be reduced, thereby avoiding sharp deterioration in performance of the antenna, ensuring that the performance of the antenna is within a proper range, and ensuring reliability of an electronic device.

In a possible implementation, the electrical connection structure includes a plurality of copper foils, and the plurality of copper foils are spaced apart along a circumferential direction of the main body portion. One end of each copper foil is electrically connected to the middle frame, and the other end of each copper foil is electrically connected to the heat dissipation plate, so that the middle frame is electrically connected to the heat dissipation plate.

The copper foils are used to implement an electrical connection between the middle frame and the heat dissipation plate. When the electrical connection between the middle frame and the heat dissipation plate is implemented, manufacturing costs and a weight of the middle frame assembly may be reduced, thereby helping reduce manufacturing costs of a weight of the electronic device.

In a possible implementation, a first groove is disposed in a surface that is of the middle frame and that faces a display, and one end of the first groove extends to the hollowed-out region. One end of the copper foil is disposed in the first groove and electrically connected to the middle frame, and a thickness of the copper foil is less than a depth of the first groove.

An electrical connection position between the copper foil and the middle frame is disposed in the first groove, and the thickness of the copper foil is less than the depth of the first groove, so that the copper foil may be prevented from protruding from the surface that is of the middle frame and that faces the display, to reduce impacting on the display, and help avoid damage to the display.

In a possible implementation, a second groove is disposed in the main body portion, there is an opening on a side that is of the second groove and that faces a side wall of the hollowed-out region, and the other end of the copper foil passes through the opening and is located in the second groove.

An electrical connection position between the copper foil and the heat dissipation plate is disposed in the second groove, so that the copper foil may be prevented from protruding from a surface that is of the heat dissipation plate and that faces the display, to reduce impacting on the display, and help avoid damage to the display.

In a possible implementation, the heat dissipation plate includes a sealing plate and a cavity cover, and the cavity cover and a partial region of the sealing plate enclose a capillary cavity. There is an avoidance opening on a side that is of the cavity cover and that faces an outer edge of the sealing plate, and a side wall of the avoidance opening and a partial region of the sealing plate enclose the second groove. The other end of the copper foil is electrically connected to a part that is of the sealing plate and that is located in the second groove. The cavity cover and a part of the sealing plate serve as the main body portion, and a part of the sealing plate serves as the connection portion.

The heat dissipation plate of this structure may be electrically connected to the copper foil in a welding manner, thereby helping improve reliability of an electrical connection between the copper foil and the heat dissipation plate. In addition, when the copper foil is welded to the heat dissipation plate, the capillary cavity may be prevented from being damaged, to ensure that the heat dissipation plate may be normally used.

In a possible implementation, a copper plated layer is disposed at a groove bottom of the second groove, and the other end of the copper foil is welded to the copper plated layer, so that the copper foil is electrically connected to the heat dissipation plate.

The copper plated layer is welded to the copper foil, thereby helping improve reliability of an electrical connection between the heat dissipation plate and the copper foil, and further improving reliability of the electrical connection between the middle frame and the heat dissipation plate.

In a possible implementation, the one end of the copper foil is welded to the middle frame, and the other end of the copper foil is welded to the connection portion.

The copper foil is electrically connected to the middle frame and the heat dissipation plate in a welding manner, thereby helping improve reliability of the electrical connection between the middle frame and the heat dissipation plate.

In a possible implementation, the one end of the copper foil is electrically connected to the middle frame by using conductive adhesive, and the other end of the copper foil is electrically connected to the main body portion by using conductive adhesive.

The copper foil is electrically connected to the middle frame and the heat dissipation plate by using the conductive adhesive, thereby helping improve a speed of connecting the copper foil to the middle frame and the heat dissipation plate.

In a possible implementation, the middle frame further has a plurality of through holes, and the plurality of through holes are spaced apart along a circumferential direction of the main body portion. The electrical connection structure includes a plurality of first welding portions, and one first welding portion is disposed in each through hole. The middle frame is welded to the connection portion by using the plurality of first welding portions, so that the middle frame is electrically connected to the heat dissipation plate.

The middle frame is welded to the heat dissipation plate by using the through holes, so that difficulty of welding the middle frame to the heat dissipation plate may be reduced, thereby reducing difficulty of electrically connecting the middle frame to the heat dissipation plate. In addition, stability of the electrical connection between the middle frame and the heat dissipation plate may be further improved.

In a possible implementation, the electrical connection structure includes a plurality of second welding portions, and the plurality of second welding portions are located between the middle frame and the connection portion and spaced apart along a circumferential direction of the main body portion. The middle frame is welded to the connection portion by using the plurality of second welding portions, so that the middle frame is electrically connected to the heat dissipation plate.

The second welding portions that connect the middle frame to the connection portion are formed in a welding manner, so that the middle frame may be electrically connected to the heat dissipation plate.

In a possible implementation, the electrical connection structure includes a plurality of spring members. The plurality of spring members are spaced apart along a circumferential direction of the main body portion, and the plurality of spring members are located between the middle frame and the connection portion. Each spring member abuts against the middle frame and the connection portion, so that the middle frame is electrically connected to the heat dissipation plate.

The middle frame is electrically connected to the heat dissipation plate by using the spring members, so that stability of the electrical connection between the middle frame and the heat dissipation plate may be improved.

In a possible implementation, the electrical connection structure is a conductive silver paste layer disposed between the middle frame and the connection portion. The middle frame is electrically connected to the connection portion by using the conductive silver paste layer, so that the middle frame is electrically connected to the heat dissipation plate.

When the middle frame and the heat dissipation plate are electrically connected by using conductive silver paste, connection strength between the heat dissipation plate and the middle frame may be improved.

In a possible implementation, in a thickness direction of the middle frame assembly, a surface that is of the middle frame and that faces away from the display is flush with a surface that is of the heat dissipation plate and that faces away from the display.

In this way, a plane that is of the middle frame assembly and that is in contact with a battery may be prevented from being not flat, thereby preventing safety of the battery from being affected.

In a possible implementation, in a thickness direction of the middle frame assembly, a surface that is of the main body portion and that faces the display is higher than the surface that is of the middle frame and that faces the display.

In this way, impacting on the display may be reduced, thereby helping avoid damage to the display.

In a possible implementation, there is a step on an inner wall of the hollowed-out region, and the connection portion laps the step of the hollowed-out region and is bonded to the step.

The step is disposed, so that the surface that is of the heat dissipation plate and that faces away from the display may be flush with the surface that is of the middle frame and that faces away from the display, thereby preventing safety of the battery from being affected.

A second aspect of this application provides an electronic device, including at least a display, a battery, a rear cover, and the middle frame assembly according to any section of the first aspect. The middle frame assembly is located between the display and the rear cover, one side of the heat dissipation plate of the middle frame assembly faces the battery, the other side of the heat dissipation plate of the middle frame assembly faces the display, and the battery is located between the heat dissipation plate of the middle frame assembly and the rear cover. The middle frame assembly is included, so that sharp deterioration in performance of an antenna can be avoided, to ensure that the performance of the antenna is within a proper range, thereby ensuring reliability of the electronic device.

### BRIEF DESCRIPTION OF DRAWINGS

FIG. 1 is a three-dimensional diagram of an electronic device according to this application;
FIG. 2 is an exploded diagram of an electronic device according to this application;
FIG. 3A is a partial sectional view of an electronic device in which a middle frame is separated from a heat dissipation plate according to this application;
FIG. 3B is a partial sectional view of an electronic device in which a heat dissipation plate is mounted on a middle frame according to this application;
FIG. 4 is a schematic rear view of a first middle frame assembly according to an embodiment of this application;
FIG. 5 is a schematic front view of the first middle frame assembly according to an embodiment of this application;
FIG. 6 is a sectional view of the middle frame assembly according to the embodiment shown in FIG. 5;
FIG. 7 is a partial enlarged view of a position near one of a plurality of copper foils of the middle frame assembly according to the embodiment shown in FIG. 5;
FIG. 8 is a schematic top view of a position near one of a plurality of copper foils of the middle frame assembly according to the embodiment shown in FIG. 5;
FIG. 9 is a sectional view of a second middle frame assembly according to an embodiment of this application;
FIG. 10 is a partial front view of a middle frame according to the shown embodiment;
FIG. 11 is a sectional view of a third middle frame assembly according to an embodiment of this application;
FIG. 12 is a sectional view of a fourth middle frame assembly according to an embodiment of this application;
FIG. 13 is a sectional view of a fifth middle frame assembly according to an embodiment of this application;
FIG. 14 is a sectional view of a sixth middle frame assembly according to an embodiment of this application; and
FIG. 15 is a sectional view of a seventh middle frame assembly according to an embodiment of this application.

### Reference numerals:

100: electronic device;
   10: middle frame assembly;
      11: middle frame;
         111: hollowed-out region; 112: first groove; 113: step; 114: third groove; 115: through hole; 116: middle plate; 117: side frame;
      12: heat dissipation plate;
         121: main body portion; 122: connection portion; 123: second groove; 124: cavity cover; 1241: avoidance opening; 125: sealing plate; 126: capillary cavity; 127: welding through hole;
      13: electrical connection structure;
         131: copper foil;
         132: first welding portion;
         133: second welding portion; 1331: welding section;
         134: spring member; 1341: sub-spring;
         135: conductive silver paste layer; 1351: conductive silver paste portion;
         136: metal screw;
         137: third welding portion;
      14: copper plated layer; 15: antenna;
   20: display; 30: rear cover; 40: battery; 50: circuit board; 60: camera module; 70: bonding member;
X: height direction;
Y: length direction; and
Z: thickness direction.

### DESCRIPTION OF EMBODIMENTS

Embodiments of this application provide an electronic device, including but not limited to a mobile or fixed terminal with a middle frame and an antenna, such as a mobile phone, a tablet computer, a notebook computer, an ultra-mobile personal computer (ultra-mobile personal computer, UMPC), a handheld computer, a walkie-talkie, a netbook, a POS machine, a personal digital assistant (personal digital assistant, PDA), an event data recorder, a wearable device, or a virtual reality device.

In embodiments of this application, an example in which a mobile phone is the foregoing electronic device is used for description. The mobile phone may be a foldable mobile phone, a bar-type mobile phone, or a slide mobile phone. The following uses the bar-type mobile phone as an example for specific description.

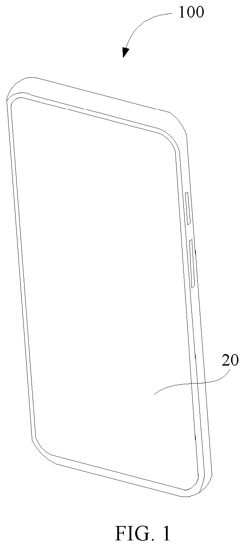

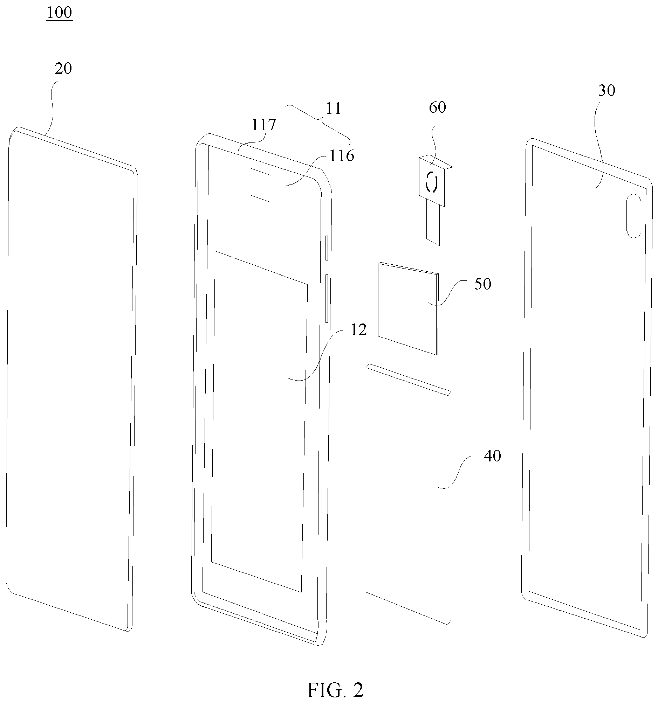

FIG. 1 is a three-dimensional diagram of an electronic device according to this application. FIG. 2 is an exploded diagram of an electronic device according to this application. Refer to FIG. 1 and FIG. 2. The electronic device 100 may include a display 20, a rear cover 30, and a middle frame 11. The middle frame 11 is located between the display 20 and the rear cover 30.

Refer to FIG. 2. The middle frame 11 may include a middle plate 116 and a side frame 117 disposed around an outer edge of the middle plate 116. An inner wall of the side frame 117 may be connected to the outer edge of the middle plate 116 to form an integral structure. A material of the middle plate 116 may be aluminum or aluminum alloy, or a material of the middle plate 116 may be stainless steel.

The electronic device 100 may further include a battery 40 and a circuit board 50. The battery 40 and the circuit board 50 may be disposed on the middle plate 116. For example, as shown in FIG. 2, the battery 40 and the circuit board 50 may be disposed in a surface that is of the middle plate 116 and that faces the rear cover 30. Alternatively, in some embodiments, the battery 40 and the circuit board 50 may be disposed in a surface that is of the middle plate 116 and that faces the display 20. Alternatively, in some embodiments, the battery 40 is located on a surface that is of the middle plate 116 and that faces the rear cover 30, and the circuit board 50 is located on a surface that is of the middle plate 116 and that faces the display 20.

The rear cover 30 may be a metal rear cover, a glass rear cover, a plastic rear cover, or a ceramic rear cover.

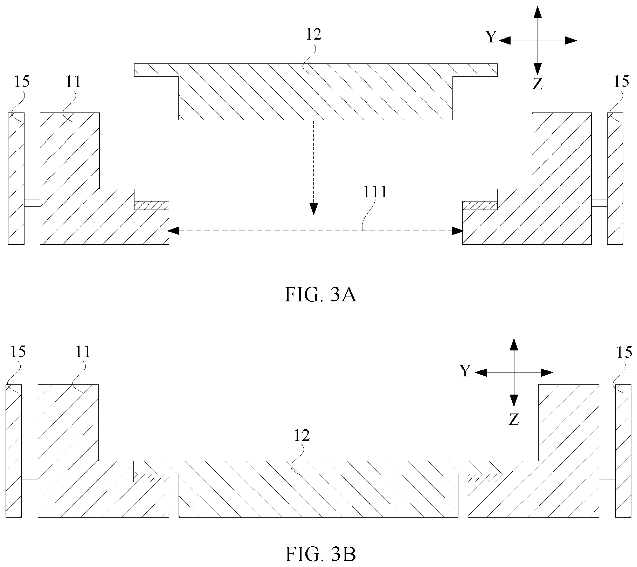

FIG. 3A is a partial sectional view of an electronic device in which a middle frame is separated from a heat dissipation plate according to this application. FIG. 3B is a partial sectional view of an electronic device in which a heat dissipation plate is mounted on a middle frame according to this application. Refer to FIG. 3A and FIG. 3B. The electronic device 100 may further include antennas 15, and the antennas 15 may be disposed on two opposite sides of the middle frame 11. A user may receive information from a network side device or send information to the network side device by using the antennas 15, to implement functions such as calling, Internet access, and game playing.

Still refer to FIG. 3A and FIG. 3B. The electronic device 100 may further include a heat dissipation plate 12, and the heat dissipation plate 12 is mounted in a hollowed-out region 111 of the middle frame 11. Two opposite sides of the heat dissipation plate 12 respectively face the battery 40 and the display 20 (as shown in FIG. 2). A heat dissipation requirement of the electronic device 100 may be met by using the heat dissipation plate 12, to ensure that the electronic device 100 works within a proper temperature range. It should be noted that, in some embodiments, the heat dissipation plate 12 may alternatively extend to cover the circuit board 50, so that the heat dissipation plate 12 may also dissipate heat for the circuit board 50.

As components such as a chip, the antennas 15, and the battery 40 in the electronic device 100 are increasingly advanced, performance of the electronic device 100 is also increasingly high. Moreover, the electronic device 100 also generates more heat. If the heat cannot be dissipated in a timely manner, a temperature of the electronic device 100 is very high, thereby affecting intuitive experience of the user. In addition, performance of the components of the electronic device 100 may deteriorate, or even the components may be damaged. Therefore, a large-area heat dissipation plate 12 may be used to meet a relatively large heat dissipation requirement of the electronic device 100, to ensure that the electronic device 100 works within a proper temperature range.

However, as an area of the heat dissipation plate 12 increases, the heat dissipation plate 12 is closer to the antennas 15 on two sides of the middle frame 11. In this case, an electromagnetic wave generated at a lap joint between the heat dissipation plate 12 and the middle frame 11 causes clutter jamming for the antennas 15 on the two sides of the middle frame 11, and consequently, performance of the antennas 15 sharply deteriorates. Therefore, how to avoid sharp deterioration in the performance of the antennas 15 when the large-area heat dissipation plate 12 is used for heat dissipation becomes an urgent problem to be resolved.

In view of this, embodiments of this application provide a middle frame assembly 10. The middle frame assembly 10 includes a middle frame 11 and a heat dissipation plate 12 that are electrically connected. The middle frame 11 and the heat dissipation plate 12 are electrically connected, so that the heat dissipation plate 12 may be grounded through the middle frame 11, and impact, on an antenna 15 that is of clutter jamming caused by an electromagnetic wave generated at a lap joint between the large-area heat dissipation plate 12 and the middle frame 11, may be reduced, thereby avoiding sharp deterioration in performance of the antenna 15, ensuring that the performance of the antenna 15 is within a proper range, and ensuring reliability of the electronic device 100.

The following describes in detail the middle frame assembly 10 provided in embodiments of this application.

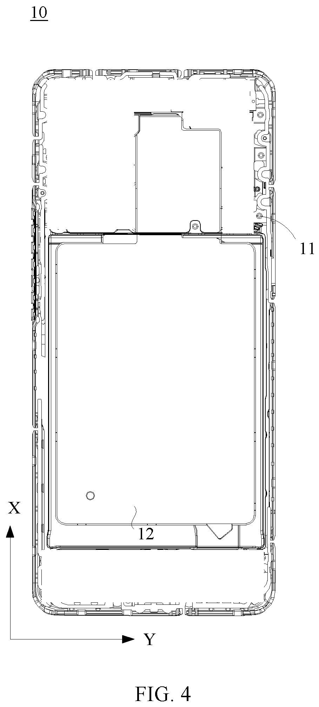

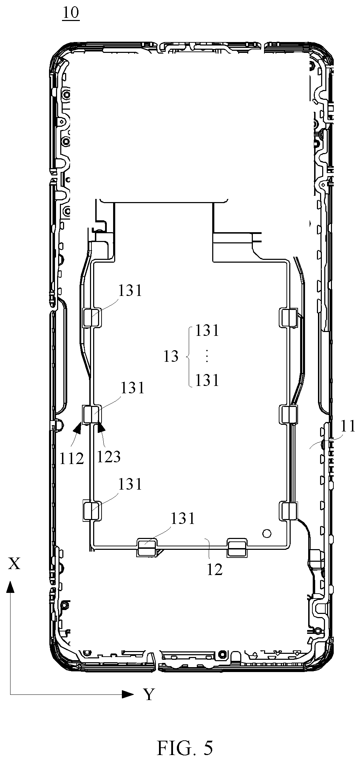

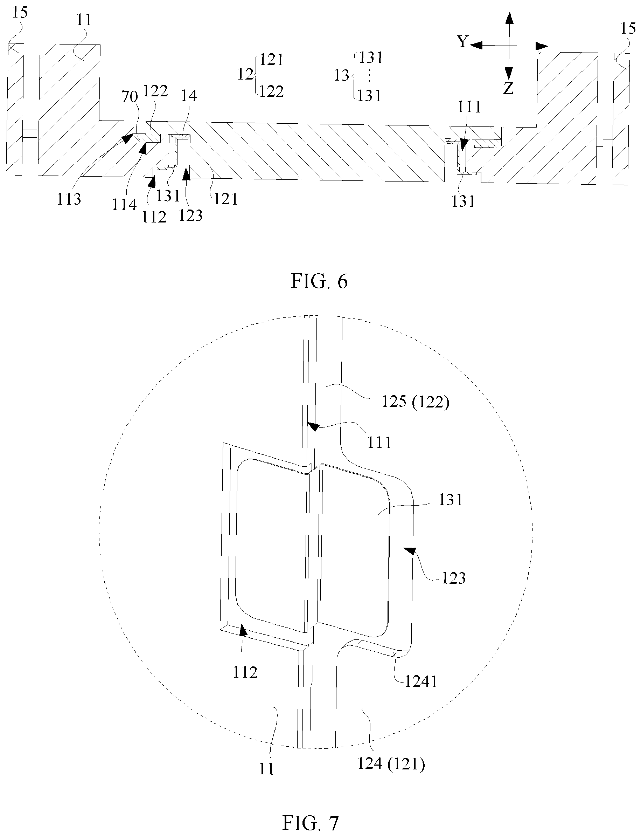

FIG. 4 is a schematic rear view of a first middle frame assembly according to an embodiment of this application. FIG. 5 is a schematic front view of the first middle frame assembly according to an embodiment of this application. FIG. 6 is a sectional view of the middle frame assembly according to the embodiment shown in FIG. 5. As shown in FIG. 4 to FIG. 6, a middle frame assembly 10 provided in this embodiment of this application includes a middle frame 11, a heat dissipation plate 12, and an electrical connection structure 13. The middle frame 11 has a hollowed-out region 111. The heat dissipation plate 12 may include a main body portion 121 and a connection portion 122, the main body portion 121 is disposed in the hollowed-out region 111, and the connection portion 122 is securely fastened to the middle frame 11. The electrical connection structure 13 is configured to electrically connect the heat dissipation plate 12 to the middle frame 11, so that the heat dissipation plate 12 is grounded through the middle frame 11.

As shown in FIG. 6, in addition to disposing the main body portion 121 in the hollowed-out region 111, in some embodiments, the main body portion 121 and at least a part of the connection portion 122 may be disposed in the hollowed-out region 111. In addition, as shown in FIG. 6, the main body portion 121 is inserted in the hollowed-out region 111, so that one side of the main body portion 121 may face a display 20, and the other side of the main body portion 121 may face a battery 40.

As shown in FIG. 6, the connection portion 122 may be disposed on a side that is of the middle frame 11 and that faces the battery 40 (that is, faces away from the display 20), so that the connection portion 122 may be in contact with a rear surface of the middle frame 11, and the heat dissipation plate 12 may be connected to the middle frame 11 in a rear-mounted manner, thereby helping improve strength of the middle frame assembly 10 and reduce a thickness of the middle frame assembly 10. The rear surface of the middle frame 11 is a surface that is of the middle frame 11 and that faces the battery 40, and is also a surface that is of the middle frame 11 and that faces away from the display 20. In addition, in a thickness direction (for example, a Z direction in FIG. 6) of the middle frame assembly 10, a surface opposite to the rear surface of the middle frame 11 is a front surface of the middle frame 11, and the front surface of the middle frame 11 is a surface that is of the middle frame 11 and that faces the display 20.

It should be noted that rear mounting means that the heat dissipation plate 12 is mounted on the middle frame 11 from the rear surface of the middle frame 11. Certainly, the heat dissipation plate 12 may alternatively be connected to the middle frame 11 in a front-mounted manner, and front mounting means that the heat dissipation plate 12 is mounted on the middle frame 11 from the front surface of the middle frame 11.

It may be understood that, as shown in FIG. 6, the hollowed-out region 111 is a through hole that penetrates the middle frame 11, and one end of the through hole faces the display 20. In addition, a shape of the hollowed-out region 111 may be determined based on a shape of the main body portion 121, and is not limited herein. For example, in some examples, the main body portion 121 is rectangular, and in this case, the hollowed-out region 111 is a rectangular through hole.

In some possible implementations, as shown in FIG. 5, the electrical connection structure 13 may include a plurality of copper foils 131, and the plurality of copper foils 131 are spaced apart along a circumferential direction of the main body portion 121. One end of each copper foil 131 is electrically connected to the middle frame 11 in a welding manner, and the other end of each copper foil 131 is electrically connected to the heat dissipation plate 12 also in the welding manner, so that the middle frame 11 is electrically connected to the heat dissipation plate 12.

Because the copper foil 131 is relatively thin and has relatively good welding performance, a weight of the copper foil 131 may be reduced, so that a weight sum of the middle frame assembly 10 may be reduced. In addition, a welding connection between the copper foil 131 and the middle frame 11 may be implemented through low-cost ultrasonic welding, so that costs of the middle frame assembly 10 may be reduced.

Because copper has good conductivity, the copper foil 131 is used to electrically connect the middle frame 11 to the heat dissipation plate 12, thereby helping further improve reliability of an electrical connection between the middle frame 11 and the heat dissipation plate 12. Certainly, in some embodiments, the copper foil 131 may alternatively be replaced with another conductive material, for example, the copper foil 131 is replaced with a gold foil or an aluminum foil.

As shown in FIG. 6, the copper foil 131 is disposed on the front surface of the middle frame 11, one end of the copper foil 131 is in contact with the front surface of the middle frame 11, and the other end of the copper foil 131 is in contact with a surface that is of the heat dissipation plate 12 and that faces the display 20. Such disposing helps avoid impact on safety of the battery 40 caused by a protrusion formed at an electrical connection position between the copper foil 131 and either of the middle frame 11 and the heat dissipation plate 12.

To improve grounding effect of the heat dissipation plate 12 being grounded through the middle frame 11, there may be at least four copper foils 131. For example, as shown in FIG. 5, there are eight copper foils 131. In addition, a larger quantity of copper foils 131 leads to higher reliability of the electrical connection between the heat dissipation plate 12 and the middle frame 11, and better grounding effect.

It should be noted that a manner of welding the copper foil 131 to the middle frame 11 and the heat dissipation plate 12 is not limited to ultrasonic welding.

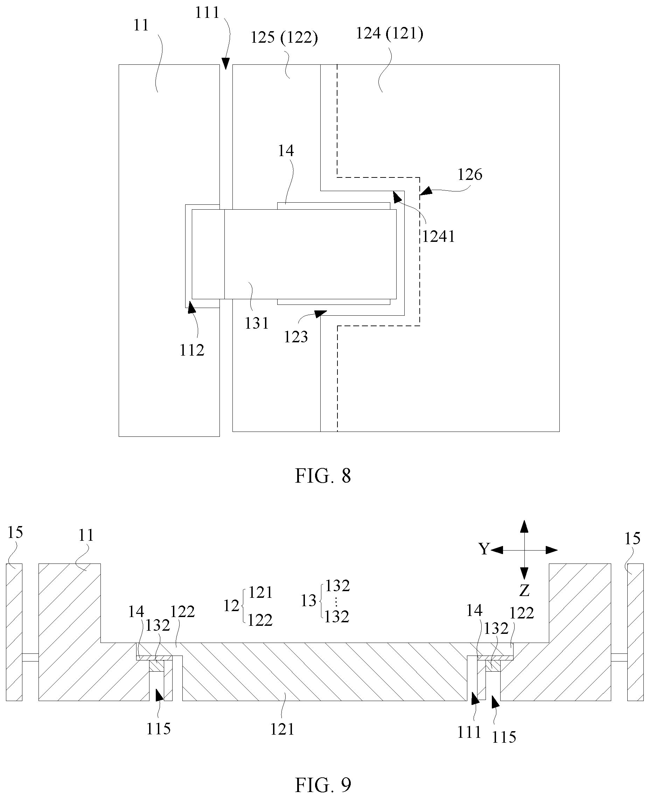

FIG. 7 is a partial enlarged view of a position near one of a plurality of copper foils of the middle frame assembly according to the embodiment shown in FIG. 5. FIG. 8 is a schematic top view of a copper foil position near one of a plurality of copper foils of the middle frame assembly according to the embodiment shown in FIG. 5. In some possible implementations, as shown in FIG. 6 to FIG. 8, a first groove 112 may be disposed in the surface that is of the middle frame 11 and that faces the display 20, and one end of the first groove 112 extends to the hollowed-out region 111. One end of the copper foil 131 is disposed in the first groove 112 and welded to the middle frame 11, and a thickness of the copper foil 131 is less than a depth of the first groove 112.

An electrical connection position between the copper foil 131 and the middle frame 11 is disposed in the first groove 112, and the thickness of the copper foil 131 is less than the depth of the first groove 112, so that the copper foil 131 may be prevented from protruding from the surface that is of the middle frame 11 and that faces the display 20, to reduce impacting on the display 20, and help avoid damage to the display 20. Impacting means that when the electronic device 100 falls, vibrates, or the like, under an impact force, the copper foil 131 protruding from the front surface of the middle frame 11 impacts the display 20, and the display 20 is likely to be damaged.

A specific shape of the first groove 112 is not limited herein. For example, as shown in FIG. 8, the first groove 112 may be a rectangular groove. Alternatively, in some embodiments, the first groove 112 may be an arc-shaped groove, a semi-circular groove, a pentagonal groove, or the like.

The depth of the first groove 112 may be determined based on the thickness of the copper foil 131, and is not limited herein. For example, in some embodiments, the depth of the first groove 112 is 0.05 mm, and the thickness of the copper foil 131 is 0.03 mm.

It may be understood that a quantity of first grooves 112 is equal to the quantity of copper foils 131.

In some possible implementations, as shown in FIG. 7 and FIG. 8, a second groove 123 may be disposed in the main body portion 121, there is an opening on a side that is of the second groove 123 and that faces a side wall of the hollowed-out region 111, and the other end of the copper foil 131 passes through the opening, is located in the second groove 123, and is welded to a groove bottom of the second groove 123. A welding position between the other end of the copper foil 131 and the heat dissipation plate 12 is disposed in the second groove 123. In one aspect, the copper foil 131 may be prevented from protruding from the surface that is of the heat dissipation plate 12 and that faces the display 20, to reduce impacting on the display 20. In another aspect, when the copper foil 131 is welded to the heat dissipation plate 12, a capillary cavity 126 of the heat dissipation plate 12 may be avoided, eliminating a case in which the heat dissipation plate 12 cannot be used due to damage to sealing of the capillary cavity 126.

A specific shape of the second groove 123 is not limited herein. For example, as shown in FIG. 7, the second groove 123 may be a rectangular groove that extends to the hollowed-out region 111 at one end. Alternatively, in some embodiments, the second groove 123 may be an arc-shaped groove, a semi-circular groove, a pentagonal groove, or the like that extends to the hollowed-out region 111 at one end.

The capillary cavity 126 is configured to accommodate a coolant, and the coolant performs heat exchange with a heat emitting component inside the electronic device 100 by using the heat dissipation plate 12, so that a temperature of the electronic device 100 remains within a proper range.

In some possible implementations, as shown in FIG. 7 and FIG. 8, the heat dissipation plate 12 may include a sealing plate 125 and a cavity cover 124, and the cavity cover 124 and a partial region of the sealing plate 125 enclose the capillary cavity 126. There is an avoidance opening 1241 on a side that is of the cavity cover 124 and that faces an outer edge of the sealing plate 125, and a side wall of the avoidance opening 1241 and a partial region of the sealing plate 125 enclose the second groove 123. The other end of the copper foil 131 is welded to a part that is of the sealing plate 125 and that is located in the second groove 123. When the heat dissipation plate 12 is electrically connected to the copper foil 131 in a welding manner, the heat dissipation plate 12 of this structure may eliminate a case in which the heat dissipation plate 12 cannot be used due to damage to the capillary cavity 126.

The cavity cover 124 and a region that is on the sealing plate 125 and that is opposite to the cavity cover 124 enclose the capillary cavity 126. In addition, the sealing plate 125 in the region and the cavity cover 124 jointly serve as the main body portion 121. Any part that is of the sealing plate 125 and that is other than a part enclosing the capillary cavity 126 may serve as the connection portion 122. Therefore, the part that is of the sealing plate 125 and that is located in the second groove 123 is also the connection portion 122.

It may be understood that the groove bottom of the second groove 123 is the sealing plate 125, and a groove wall of the second groove 123 is the cavity cover 124. In addition, the opening of the second groove 123 is equivalent to the avoidance opening 1241.

In some possible implementations, as shown in FIG. 6 to FIG. 8, a copper plated layer 14 may be disposed at the groove bottom of the second groove 123, and the other end of the copper foil 131 is welded to the copper plated layer 14, so that the copper foil 131 is electrically connected to the heat dissipation plate 12. Because copper has good welding performance, the copper plated layer 14 is welded to the copper foil 131, thereby helping improve reliability of an electrical connection between the heat dissipation plate 12 and the copper foil 131, and further improving reliability of the electrical connection between the middle frame 11 and the heat dissipation plate 12.

Because the groove bottom of the second groove 123 is the sealing plate 125, the copper plated layer 14 is disposed on the sealing plate 125.

In some possible implementations, as shown in FIG. 7, in the thickness direction of the middle frame assembly 10, the surface that is of the middle frame 11 and that faces away from the display 20 is flush with a surface that is of the heat dissipation plate 12 and that faces away from the display 20, thereby ensuring that a plane that cooperates with the battery 40 is a flat surface with no protrusion that affects safety of the battery 40.

In some possible implementations, in the thickness direction of the middle frame assembly 10, a surface that is of the main body portion 121 and that faces the display 20 is flush with the surface that is of the middle frame 11 and that faces the display 20, thereby reducing impacting on the display 20, and helping avoid damage to the display 20. In addition, a heat dissipation capability of the heat dissipation plate 12 may be further improved.

It may be understood that the surface that is of the heat dissipation plate 12 and that faces the display 20 is mainly the surface that is of the main body portion 121 and that faces the display 20. When the surface that is of the main body portion 121 and that faces the display 20 is flat, the surface that is of the main body portion 121 and that faces the display 20 is flush with the surface that is of the middle frame 11 and that faces away from the display 20. When the surface that is of the main body portion 121 and that faces the display 20 is not flat, the surface that is of the main body portion 121 and that faces the display 20 is a region that is closest to the display and that is on the surface that is of the main body portion 121 and that faces the display 20.

It should be noted that, in addition to the surface that is of the middle frame 11 and that faces the display 20 being flush with the surface that is of the main body portion 121 and that faces the display 20, in some embodiments, in the thickness direction of the middle frame assembly 10, the surface that is of the main body portion 121 and that faces the display 20 may be higher than the surface that is of the middle frame 11 and that faces the display 20, thereby reducing impacting on the display 20, and helping avoid damage to the display 20. Being higher than may be understood as the surface that is of the middle frame 11 and that faces the display 20 being closer to the display 20. In other words, the surface that is of the middle frame 11 and that faces the display 20 is located between the display 20 and the surface that is of the main body portion 121 and that faces the display 20.

In some possible implementations, as shown in FIG. 6, there is a step 113 on an inner wall of the hollowed-out region 111, and the connection portion 122 laps the step 113 of the hollowed-out region 111 and is bonded to the step 113, so that a surface that is of the heat dissipation plate 12 and that faces a rear cover 30 is flush with a surface that is of the middle frame 11 and that faces the rear cover 30, to ensure normal use of the battery 40.

The connection portion 122 may be bonded to the middle frame 11 by using a bonding member 70 such as glue or a double-sided tape.

Because the bonding member 70 has a specific thickness, to avoid an increase in a thickness between the rear surface of the middle frame 11 and the surface that is of the main body portion 121 and that faces the display 20, in some embodiments, a third groove 114 is disposed on the rear surface of the middle frame 11, and the bonding member 70 is disposed in the third groove 114.

To further improve electrical connection effect between the heat dissipation plate 12 and the middle frame 11, in some embodiments, the bonding member 70 may be conductive adhesive. In addition to bonding the middle frame 11 to the connection portion 122, the conductive adhesive may electrically connect the middle frame 11 to the connection portion 122 by cooperating with the copper foil 131, thereby further improving the electrical connection effect between the heat dissipation plate 12 and the middle frame 11.

In the foregoing content, the copper foil 131 is electrically connected to the middle frame 11 and the connection portion 122 of the heat dissipation plate 12 in the welding manner. However, in some possible implementations, the copper foil 131 may alternatively be electrically connected to the middle frame 11 and the connection portion 122 of the heat dissipation plate 12 by using conductive adhesive (not shown in the figure). Alternatively, in the foregoing content, the copper foil 131 is electrically connected to the connection portion of the heat dissipation plate 12. However, in some possible implementations, the copper foil 131 may alternatively be electrically connected to the main body portion 121 of the heat dissipation plate 12. Because the copper foil 131 is disposed on a side that is of the middle frame 11 and that faces the display 20, to avoid damage to the capillary cavity 126 caused by a connection between the copper foil 131 and the main body portion 121, the copper foil 131 may be electrically connected to the main body portion 121 by using conductive adhesive.

It should be noted that, when the copper foil 131 is electrically connected, by using conductive adhesive, to the surface that is of the main body portion 121 and that faces the display 20, in the thickness direction of the middle frame assembly 10, a surface that is of the copper foil 131 and that faces the display 20 is higher than the surface that is of the middle frame 11 and that faces the display 20. In this way, impacting on the display 20 may be reduced.

In the foregoing content, the copper foil 131 is used to electrically connect the middle frame 11 to the heat dissipation plate 12. However, an electrical connection structure 13 of another structure may alternatively be used to electrically connect the middle frame 11 to the heat dissipation plate 12. The following describes several electrical connection structures 13 of other structures.

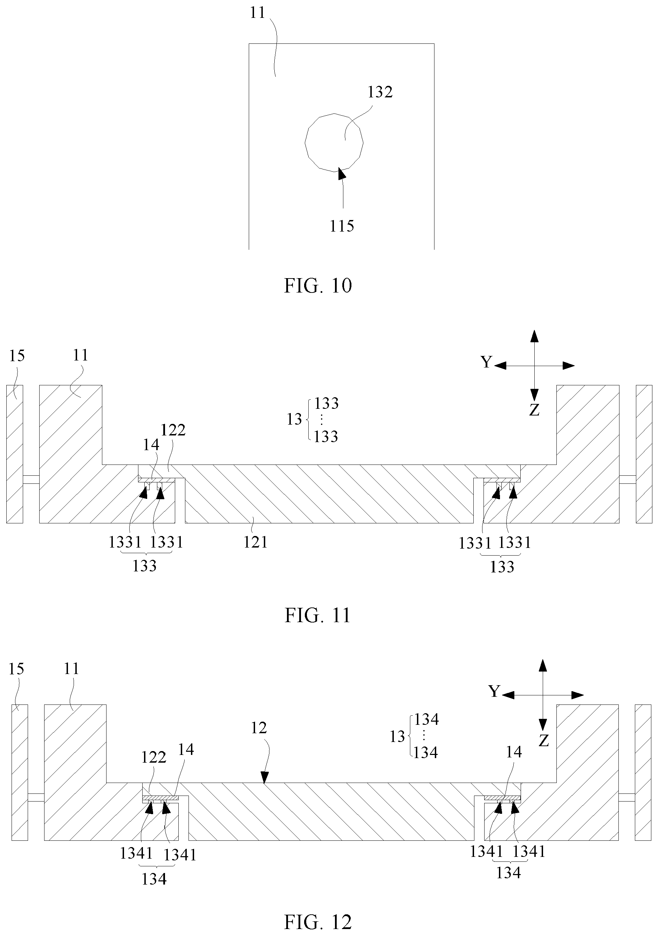

FIG. 9 is a sectional view of a second middle frame assembly according to an embodiment of this application. FIG. 10 is a partial front view of a middle frame according to the shown embodiment. In some possible implementations, as shown in FIG. 9 and FIG. 10, the middle frame 11 may further have a plurality of through holes 115, and the plurality of through holes 115 are spaced apart along a circumferential direction of the main body portion 121. The electrical connection structure 13 may include a plurality of first welding portions 132, and one first welding portion 132 is disposed in each through hole 115. The middle frame 11 is welded to the connection portion 122 by using the plurality of first welding portions 132, so that the middle frame 11 is electrically connected to the heat dissipation plate 12. The middle frame 11 is welded to the heat dissipation plate 12 by using the through holes 115, so that difficulty of welding the middle frame 11 to the heat dissipation plate 12 may be reduced, thereby reducing difficulty of electrically connecting the middle frame 11 to the heat dissipation plate 12. In addition, stability of the electrical connection between the middle frame 11 and the heat dissipation plate 12 may be further improved.

It should be noted that the connection portion 122 is disposed on a side that is of the middle frame 11 and that faces away from the display 20. Therefore, the heat dissipation plate 12 is welded to the middle frame 11 from the front surface of the middle frame 11. This may ensure that no protrusion exists on a surface that is of the middle frame assembly 10 and that cooperates with the battery 40, to improve safety of the battery 40. In addition, the heat dissipation plate 12 may alternatively be mounted on the middle frame 11 in a rear-mounted manner, thereby helping reduce a thickness of the middle frame 11, and further reducing a thickness of the middle frame assembly 10.

It may be understood that the first welding portions 132 are welding structures formed by welding the middle frame 11 to the connection portion 122 by using the through holes 115.

To improve electrical connection effect between the middle frame 11 and the connection portion 122, in some embodiments, as shown in FIG. 9, a copper plated layer 14 may be further disposed on a surface that is of the connection portion 122 and that is in contact with the middle frame 11, and a welding connection to the middle frame 11 is implemented by using the copper plated layer 14.

Because the heat dissipation plate 12 is securely fastened to the middle frame 11 in a bonding manner, to further improve electrical connection effect between the middle frame 11 and the heat dissipation plate 12, in some embodiments, the middle frame 11 may alternatively be securely fastened to the heat dissipation plate 12 by using conductive adhesive (not shown in the figure), and the conductive adhesive cooperates with the first welding portions 132, thereby helping further improve reliability of the electrical connection between the middle frame 11 and the heat dissipation plate 12.

FIG. 11 is a sectional view of a third middle frame assembly according to an embodiment of this application. In some possible implementations, as shown in FIG. 11, the electrical connection structure 13 may include a plurality of second welding portions 133, the plurality of second welding portions 133 are located between the middle frame 11 and the connection portion 122, and the plurality of second welding portions 133 are spaced apart along a circumferential direction of the main body portion 121. The middle frame 11 is welded to the connection portion 122 by using the plurality of second welding portions 133, so that the middle frame 11 is electrically connected to the heat dissipation plate 12, and the heat dissipation plate 12 is grounded through the middle frame 11, thereby avoiding sharp deterioration in performance of an antenna 15.

It should be noted that the second welding portions 133 are welding structures formed by welding the middle frame 11 to the connection portion 122. Specifically, the middle frame 11 is connected to the connection portion 122 after being penetrated through laser welding on the surface that is of the middle frame 11 and that faces the display 20, thereby implementing the electrical connection between the middle frame 11 and the heat dissipation plate 12.

It should be further noted that a welding manner of welding the middle frame 11 to the connection portion 122 includes but is not limited to laser welding.

To improve electrical connection effect between the connection portion 122 and the middle frame 11, in some embodiments, as shown in FIG. 11, the second welding portion 133 may include two welding sections 1331 that are spaced apart.

To improve reliability of the electrical connection between the middle frame 11 and the heat dissipation plate 12, in some embodiments, as shown in FIG. 11, a copper plated layer 14 may be disposed on the connection portion 122, and the copper plated layer 14 is located between the middle frame 11 and the connection portion 122. Therefore, the second welding portions 133 are located between the copper plated layer 14 and the middle frame 11. Correspondingly, the second connection portion 122 is a welding structure formed by welding the middle frame 11 to the copper plated layer 14.

FIG. 12 is a sectional view of a fourth middle frame assembly according to an embodiment of this application. In some possible implementations, as shown in FIG. 12, the electrical connection structure 13 may include a plurality of spring members 134. The plurality of spring members 134 are spaced apart along a circumferential direction of the main body portion 121, and the plurality of spring members 134 are located between the middle frame 11 and the connection portion 122. Each spring member 134 abuts against the middle frame 11 and the connection portion 122, so that the middle frame 11 is electrically connected to the heat dissipation plate 12. Because the spring member 134 is elastic, the spring member 134 may be in close contact with the middle frame 11 and the heat dissipation plate 12, so that stability of the electrical connection between the middle frame 11 and the heat dissipation plate 12 may be improved.

To improve reliability of the electrical connection between the middle frame 11 and the heat dissipation plate 12, in some embodiments, as shown in FIG. 12, each spring member 134 may include two sub-springs 1341 that are spaced apart.

To reduce a thickness of the middle frame assembly 10, in some embodiments, the sub-spring 1341 may be an ultra-thin spring, to avoid a very large spacing between the connection portion 122 and the middle frame 11 caused by a very thick sub-spring 1341.

In some embodiments, as shown in FIG. 12, a copper plated layer 14 may be disposed on the connection portion 122, and the spring members 134 abut against the copper plated layer 14 and the middle frame 11, thereby helping further improve reliability of the electrical connection between the middle frame 11 and the heat dissipation plate 12.

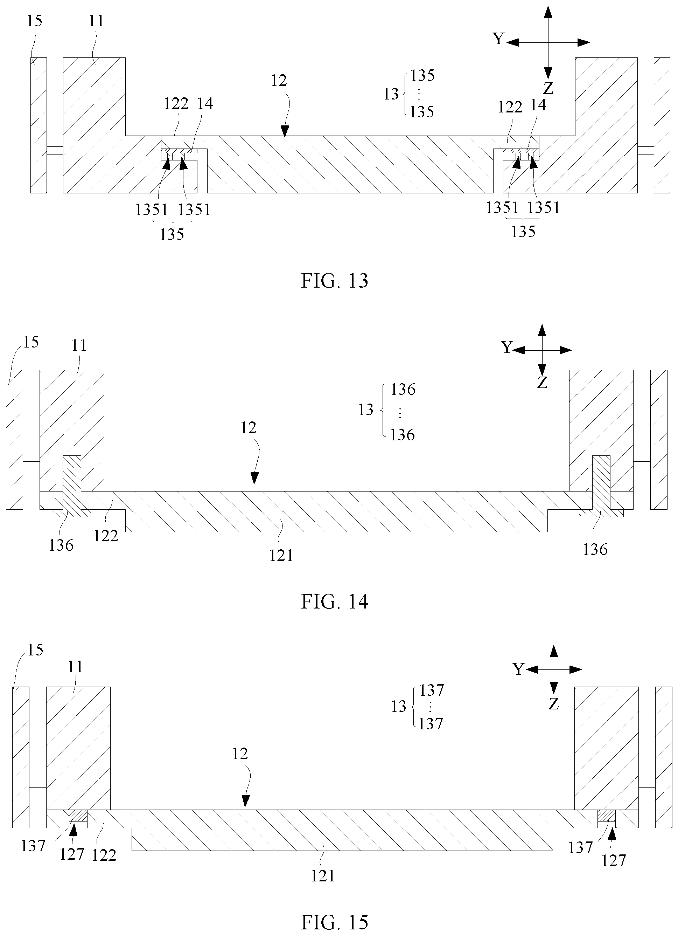

FIG. 13 is a sectional view of a fifth middle frame assembly according to an embodiment of this application. In some possible implementations, as shown in FIG. 13, the electrical connection structure 13 may be a conductive silver paste layer 135 disposed between the middle frame 11 and the connection portion 122. The middle frame 11 is electrically connected to the connection portion 122 by using the conductive silver paste layer 135, so that the middle frame 11 is electrically connected to the heat dissipation plate 12. When the middle frame 11 and the heat dissipation plate 12 are electrically connected by using conductive silver paste, connection strength between the heat dissipation plate 12 and the middle frame 11 may be improved.

To further improve reliability of the electrical connection between the middle frame 11 and the heat dissipation plate 12, in some embodiments, as shown in FIG. 13, a copper plated layer 14 may be disposed on the connection portion 122, the conductive silver paste layer 135 is located between the copper plated layer 14 and the middle frame 11, and the conductive silver paste layer 135 is electrically connected to the connection portion 122 by using the copper plated layer 14.

In some embodiments, as shown in FIG. 13, the conductive silver paste layer 135 may include two conductive silver paste portions 1351 that are spaced apart, to improve reliability of the electrical connection between the middle frame 11 and the heat dissipation plate 12.

FIG. 14 is a sectional view of a sixth middle frame assembly according to an embodiment of this application. In some possible implementations, as shown in FIG. 14, the electrical connection structure 13 may include a plurality of metal screws 136, and the plurality of metal screws 136 are spaced apart along a circumferential direction of the main body portion 121. The connection portion 122 is located on a side that is of the middle frame 11 and that faces the display 20 and is in contact with the middle frame 11, and the connection portion 122 is fastened to the middle frame 11 by using the screws. When fastening the heat dissipation plate 12 to the middle frame 11, the metal screws 136 further enable the middle frame 11 to be electrically connected to the middle frame 11, to implement grounding.

FIG. 15 is a sectional view of a seventh middle frame assembly according to an embodiment of this application. In some possible implementations, as shown in FIG. 15, the electrical connection structure 13 may include a plurality of third welding portions 137. The connection portion 122 is disposed on the front surface of the middle frame 11, a plurality of welding through holes 127 are disposed in the connection portion 122, and the plurality of welding through holes 127 are spaced apart along a circumferential direction of the main body portion 121. One third welding portion 137 is disposed in each welding through hole 127. The connection portion 122 is electrically connected to the middle frame 11 by using the third welding portions 137, so that the heat dissipation plate 12 is grounded through the middle frame 11.

It may be understood that the third welding portions 137 are welding structures formed by welding the middle frame 11 to the connection portion 122 by using the welding through holes 127.

In the description of embodiments of this application, it should be noted that, unless otherwise explicitly stipulated and restricted, terms "installation", "joint connection", and "connection" should be understood broadly, which, for example, may be a fixed connection, or may be an indirect connection by using a medium, or may be an internal communication between two components, or may be an interactive relationship between two components. A person of ordinary skill in the art may understand specific meanings of the foregoing terms in embodiments of this application based on specific cases.

In embodiments of this application, it is implied that an apparatus or element in question needs to have a particular orientation, or needs to be constructed and operated in a particular orientation, and therefore cannot be construed as a limitation on embodiments of this application. In the description of embodiments of this application, unless otherwise exactly and specifically stipulated, "a plurality of" means two or more.

In the specification, claims, and accompanying drawings of embodiments of this application, the terms "first", "second", "third", "fourth", and so on (if existent) are intended to distinguish between similar objects but do not necessarily indicate a specific order or sequence. It may be understood that the data used in such a way is interchangeable in proper circumstances, so that embodiments of this application described herein can be implemented in other sequences than the sequence illustrated or described herein. In addition, the terms "include" and "have" and any other variants are intended to cover the non-exclusive inclusion. For example, a process, method, system, product, or device that includes a list of steps or units is not necessarily limited to those expressly listed steps or units, but may include other steps or units not expressly listed or inherent to such a process, method, product, or device.

The term "a plurality of" in this specification means two or more. The term "and/or" in this specification describes only an association relationship between associated objects and indicates that three relationships may exist. For example, A and/or B may indicate the following three cases: Only A exists, both A and B exist, and only B exists. In addition, a character "/" in this specification usually indicates an "or" relationship between associated objects, and a character "/" in a formula usually indicates a "divisible" relationship between associated objects.

It may be understood that various numbers in embodiments of this application are merely used for differentiation for ease of description, and are not intended to limit the scope of embodiments of this application.

## Claims

1. A middle frame assembly, comprising a middle frame, a heat dissipation plate, and an electrical connection structure, wherein
the middle frame has a hollowed-out region;
the heat dissipation plate comprises a main body portion and a connection portion, at least the main body portion of the heat dissipation plate is disposed in the hollowed-out region, and the connection portion is securely fastened to the middle frame; and
the electrical connection structure is configured to electrically connect the heat dissipation plate to the middle frame, so that the heat dissipation plate is grounded through the middle frame.

2. The middle frame assembly according to claim 1, wherein the electrical connection structure comprises a plurality of copper foils, and the plurality of copper foils are spaced apart along a circumferential direction of the main body portion; and
one end of each copper foil is electrically connected to the middle frame, and the other end of each copper foil is electrically connected to the heat dissipation plate, so that the middle frame is electrically connected to the heat dissipation plate.

3. The middle frame assembly according to claim 2, wherein a first groove is disposed in a surface that is of the middle frame and that faces a display, and one end of the first groove extends to the hollowed-out region; and
one end of the copper foil is disposed in the first groove and electrically connected to the middle frame, and a thickness of the copper foil is less than a depth of the first groove.

4. The middle frame assembly according to claim 2 or 3, wherein a second groove is disposed in the main body portion, there is an opening on a side that is of the second groove and that faces a side wall of the hollowed-out region, and the other end of the copper foil passes through the opening and is located in the second groove.

5. The middle frame assembly according to claim 4, wherein the heat dissipation plate comprises a sealing plate and a cavity cover, and the cavity cover and a partial region of the sealing plate enclose a capillary cavity;
there is an avoidance opening on a side that is of the cavity cover and that faces an outer edge of the sealing plate, and a side wall of the avoidance opening and a partial region of the sealing plate enclose the second groove;
the other end of the copper foil is electrically connected to a part that is of the sealing plate and that is located in the second groove; and
the cavity cover and a part of the sealing plate serve as the main body portion, and a part of the sealing plate serves as the connection portion.

6. The middle frame assembly according to claim 4 or 5, wherein a copper plated layer is disposed at a groove bottom of the second groove, and the other end of the copper foil is welded to the copper plated layer, so that the copper foil is electrically connected to the heat dissipation plate.

7. The middle frame assembly according to any one of claims 2 to 6, wherein the one end of the copper foil is welded to the middle frame, and the other end of the copper foil is welded to the connection portion.

8. The middle frame assembly according to any one of claims 2 to 5, wherein the one end of the copper foil is electrically connected to the middle frame by using conductive adhesive, and the other end of the copper foil is electrically connected to the main body portion by using conductive adhesive.

9. The middle frame assembly according to claim 1, wherein the middle frame further has a plurality of through holes, and the plurality of through holes are spaced apart along a circumferential direction of the main body portion;
the electrical connection structure comprises a plurality of first welding portions, and one first welding portion is disposed in each through hole; and
the middle frame is welded to the connection portion by using the plurality of first welding portions, so that the middle frame is electrically connected to the heat dissipation plate.

10. The middle frame assembly according to claim 1, wherein the electrical connection structure comprises a plurality of second welding portions, and the plurality of second welding portions are located between the middle frame and the connection portion and spaced apart along a circumferential direction of the main body portion; and
the middle frame is welded to the connection portion by using the plurality of second welding portions, so that the middle frame is electrically connected to the heat dissipation plate.

11. The middle frame assembly according to claim 1, wherein the electrical connection structure comprises a plurality of spring members;
the plurality of spring members are spaced apart along a circumferential direction of the main body portion, and the plurality of spring members are located between the middle frame and the connection portion; and
each spring member abuts against the middle frame and the connection portion, so that the middle frame is electrically connected to the heat dissipation plate.

12. The middle frame assembly according to claim 1, wherein the electrical connection structure is a conductive silver paste layer disposed between the middle frame and the connection portion; and
the middle frame is electrically connected to the connection portion by using the conductive silver paste layer, so that the middle frame is electrically connected to the heat dissipation plate.

13. The middle frame assembly according to any one of claims 1 to 12, wherein in a thickness direction of the middle frame assembly, a surface that is of the middle frame and that faces away from the display is flush with a surface that is of the heat dissipation plate and that faces away from the display; or
in a thickness direction of the middle frame assembly, a surface that is of the main body portion and that faces the display is higher than the surface that is of the middle frame and that faces the display.

14. The middle frame assembly according to any one of claims 1 to 12, wherein there is a step on an inner wall of the hollowed-out region, and the connection portion laps the step of the hollowed-out region and is bonded to the step.

15. An electronic device, comprising a display, a battery, a rear cover, and the middle frame assembly according to any one of claims 1 to 14, wherein
the middle frame assembly is located between the display and the rear cover, one side of the heat dissipation plate of the middle frame assembly faces the battery, the other side of the heat dissipation plate of the middle frame assembly faces the display, and the battery is located between the heat dissipation plate of the middle frame assembly and the rear cover.
